(19) Europäisches Patentamt
European Patent Office
Office européen des brevets

(11) EP 0 427 260 B1

(12) EUROPEAN PATENT SPECIFICATION

(45) Date of publication and mention
of the grant of the patent:
**31.01.1996 Bulletin 1996/05**

(51) Int Cl.6: **G11C 16/06**, G11C 29/00

(21) Application number: 90121404.9

(22) Date of filing: **08.11.1990**

(54) **Non-volatile memory devices**

Nicht-flüchtige Speicheranordnungen

Dispositif de mémoires non-volatiles

(84) Designated Contracting States:
**DE FR GB**

(30) Priority: **08.11.1989 JP 290704/89**

(43) Date of publication of application:
**15.05.1991 Bulletin 1991/20**

(73) Proprietor: **FUJITSU LIMITED**
**Kawasaki-shi, Kanagawa 211 (JP)**

(72) Inventors:
• **Takashina, Nobuaki, c/o Fujitsu Ltd.**
**Kawasaki-shi, Kanagawa 211 (JP)**
• **Akaogi, Takao, c/o Fujitsu Ltd.**
**Kawasaki-shi, Kanagawa 211 (JP)**

(74) Representative: **Sunderland, James Harry et al**
**London WC2A 1AT (GB)**

(56) References cited:
**EP-A- 0 144 710**          **EP-A- 0 155 709**
**EP-A- 0 231 903**          **EP-A- 0 306 990**
**EP-A- 0 314 180**

# Description

The present invention relates to non-volatile memory devices, for example erasable programmable read only memories having redundant cell arrays. More particularly, the present invention is concerned with provisions for testing such memories.

Erasable programmable read only memories (EPROM) are being designed with increased memory capacity. In order to simultaneously realise enlargements of structural scale, that is, a greater number of memory cells in such devices, and reductions in size, elements and wiring layers are being further microminiaturised, thereby reducing the manufacturing yield of operable cells in each device. Accordingly, it has been proposed to use so-called redundant cell arrays. When a software test detects a failure in a certain bit line or word line, a cell array including the defective bit line or word line is replaced with a stand-by or redundant cell array. The address corresponding to the defective cell array is assigned to the stand-by cell array so that the EPROM can operate normally. Thus, after the redundant cell array has been assigned an address, the EPROM can carry out write operation and read operation for individual cells one by one in accordance with the sequence of addresses and can continue normal operation, even though a failure occurred in the defective cell array.

Usually, a redundant cell array EPROM includes the following structure. A cell matrix consisting of many memory elements (for example FAMOS transistors having each a control gate and a floating gate) located at respective intersections of word lines and bit lines is structured to receive signals supplied by a plurality of address signal lines having row decoders and column decoders. The decoders select necessary cells. Here, a redundant address memory circuit is provided to store addresses corresponding to each defective bit or word line in order that the defective bit line and word line may be effectively replaced. When a memory address of the redundant address memory circuit matches with information output from the column decoder and row decoder, the column decoder and row decoder are denied access to the defective memory cells and access is routed to the redundant cell arrays.

With nonvolatile memory devices as explained previously, charges accumulated in defective cells can be lost, for example, due to irregular crystal generation or irregular reduction in gate insulation film thickness. A process by which defective cells may be identified will be explained hereunder in detail.

In an EPROM having redundant cell arrays, writing of information into the cells of the EPROM is carried out for each cell in accordance with the sequence of addresses, which takes a relatively long time, due to the write characteristics of the EPROM. The EPROM is required to supply enough current to cells to generate avalanche breakdown, but it is not feasible to make a write circuit having sufficient current supply capability for supplying such heavy current to all cells at once. In other words, it is not feasible to simultaneously write information to all of the cells.

Moreover, the read operation is carried out in relation to individual cells in accordance with the sequence of addresses. From the viewpoint of circuit structure, it is nearly impossible to simultaneously carry out write or read operations to all cells, unless the circuit design is substantially modified.

As indicated above, a longer time is taken for read and write operations as the number of memory cells increases. For instance, about 15 seconds is taken for writing information to all cells in a 4 megabit EPROM. As memory capacity increases further, the problem of longer write and read times will become more serious. In addition, if a stress test is carried out for each individual cell, one by one, an additional time delay occurs in the manufacturing of the semiconductor memory devices, which increases production costs and decreases productivity per unit time in a mass production system.

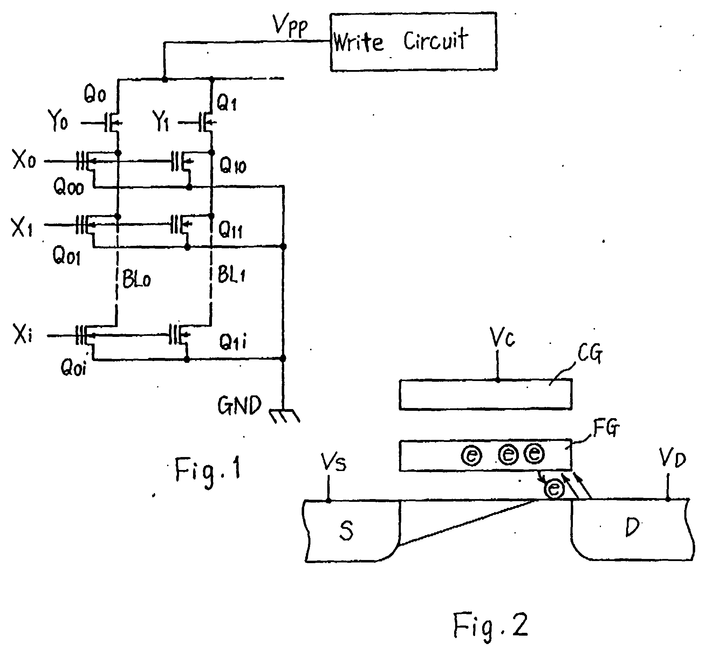

Stress testing of memory cells will now be explained with reference to Fig. 1 and Fig. 2, with a general explanation of the memory cells. These subjects are described in greater detail in U.S. Patent No. 4,543,647, entitled "Electrically Programmable Non-volatile Semiconductor Memory Device".

Fig. 1 is a diagram for assistance in explaining the general operation of an EPROM. In Fig. 1, a high voltage generated by a write circuit is supplied to a cell matrix through a bus line. Individual capacitor cells of the cell matrix are N-channel-type MOSFETs Q00 to Q1i with drains connected to bit lines BL0, BL1, ..., gates connected to word lines X0, X1, ..., Xi and sources connected to GND. Moreover, each bit line is structured so that the desired line is selected when a transistor Q0, Q1 (a column gate) for bit line selection turns ON (Y0, Y2).

Fig. 2 is a diagram for assistance in explaining memory cells and gives a sectional view of a capacitor cell of Fig. 1. In this Figure, a voltage VS is indicated to be applied to source region S, and a voltage VD is applied to drain region D. A control gate CG to which a voltage VC is applied and a floating gate FG for accumulating charges are insulated from each other and layered at the surface between the source and drain.

When a write operation is carried out in a memory cell of the EPROM, the voltage VS is set to 0 volts and the voltages VC and VD are set to a high voltage (H), such as voltages VC and VD are set to a high voltage (H), such as 12.5 V. In order to write, for example, to the memory cell Q00 in Fig. 1, Y0 is set to a high voltage, for example, to 5 V to turn ON the column gate Q0. Thereby, an output voltage VPP of the write circuit is applied to the bit line BL0. VPP is also applied to the word line X0. When VS = 0, VC = VD = VPP, electrons e enter the floating gate FG through the insulation layer, changing the threshold voltage of this memory cell FET. This completes the cell writing process.

However, when a write operation is carried out in respect of cell Q00, the drain of cell Q01 is also set to VPP, the source thereof to L (OV) and the control gate CG becomes L. Therefore, an intense field is generated between the drain D and floating gate FG. If information is already written to the cell Q01 and the gate insulation film is defective, electrons are released from the floating gate FG due to the intense field and information may be permanently erased.

In order to identify and reject a memory cell containing a defective gate insulation film, a write stress test is effected. After writing is carried out in respect of all cells, the cells are set to a condition similar to that described above for Q01, namely VD = VPP, VC = VS = L. Thereafter, any cells from which information has been deleted are identified.

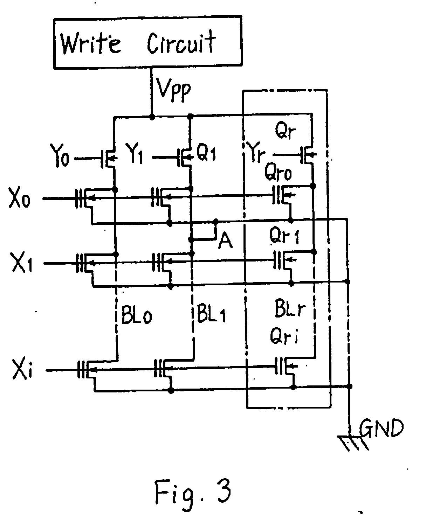

However, the write stress test cannot be executed if the cell array is short-circuited to the ground line (GND). The reason for this will be explained with reference to Fig. 3. The circuit of Fig. 3 resembles the circuit of Fig. 1, but is different in that redundant bit lines (e.g. bit line BLr having cells Qr0 to Qri) are provided for replacing defective bit lines. In addition, the bit line BL1 is short-circuited with the GND line at the point A of such bit line BL1. As shown in Fig. 3, if the bit line BL1 is short-circuited with the ground line at the point A, when all cells are set to the condition, VD = VPP, VC = VS = L (Y0, Y1 are set to H level, while X0, X1 are set to L level) in the write stress test, a heavy current flows through the path VPP - Q1 - A - GND. When this current exceeds the current supply capability of the write circuit, VPP drops below 12.5 V to a lower value. Thereby, the write stress test cannot be properly executed.

The short-circuit of the ground line to the bit line can be avoided by using a redundant bit line. The redundant bit line BLr is enclosed by a chain line in Fig. 3. Like the other bit lines BL0, BL1, ..., the redundant bit line BLr has a selection gate Qr and memory cells, Qr0, Qr1, ..., Qri. If the bit line BL1 is defective, a redundant bit BLr may be used in place of the bit line BL1 (Yr is set to H in place of setting Y1 to H). Thereby, if there are at least as many redundant bit lines as there are defective bit lines, it is not necessary to discard the entire memory.

However, the write stress test cannot be conducted efficiently for such memories, as will be seen.

As indicated above, carrying out the stress testing of cells in a sequence of individual cells would be problematic because it would be inefficient and time-consuming. However, since it is unnecessary to generate avalanche breakdown in the cells to generate stress, a heavy current is not required, and it should be considered possible to generate stress by supplying a predetermined voltage simultaneously to all cells. But, if a defective cells array exists, it is not feasible to apply a predetermined voltage to all cells at one time. If a part of a wiring layer is short-circuited when a predetermined voltage is applied simultaneously to all cells, current supplied from the write circuit flows to GND. If the current supply capability of the write circuit is limited, the voltage drops below the required voltage. This is a problem because sufficient stress is not applied to the cells and a normal stress test cannot be executed.

Japanese Patent No. 63-258000 discloses the concept of increasing the current supply capability of the write circuit to a sufficiently large value to compensate for a part of the current flowing into GND. However, this concept has limitations when applied to further microminiaturised memory devices because when a current higher than an allowable value flows into the microminiaturised wiring layers, the wiring layers are burned out or broken due to the generation of electromigration in which the flow of electrons pushes away the particles forming the wiring layer.

According to the present invention there is provided a semiconductor non-volatile memory device, having a normal operating mode and a test mode, comprising:-

a plurality of bit lines;
a plurality of word lines which intersect said bit lines;
a plurality of non-volatile memory cells, each having a drain, a control gate and a source, the cells being connected to said bit lines and said word lines where said bit lines and said word lines intersect, with the drains connected to said bit lines and the control gates connected to said word lines; and
a supply line for supplying at least one predetermined potential to the sources of all of said memory cells;
characterised by
means for electrically isolating the sources of said memory cells from said supply line responsive to a control signal, said isolating means including a switch circuit which is turned on to supply said predetermined potential to the sources of said memory cells commonly during the normal operating mode, said switch circuit being turned off during the test mode to isolate said supply line from the sources of said memory cells.

According to the present invention there is also provided such a semiconductor non-volatile memory device, being an erasable programmable memory, wherein

some of said bit lines are used as redundant bit lines, the device further comprises a write circuit for permanently storing information in selected said memory cells, said bit lines also being connected to said write circuit, and
the said means for electrically isolating said sources from said supply line are employed for the purpose of conducting a stress test on all of said memory cells simultaneously.

According to the present invention there is further provided a method for testing a semiconductor non-volatile memory device having a plurality of bit lines, a plurality of word lines which intersect the bit lines, and a plurality of non-volatile memory cell transistors, each having a drain, a control gate and a source, connected to the bit lines and the word lines where the bit lines and the word lines intersect, with the drains connected to said bit lines and the control gates connected to said word lines, the sources having a connection to a ground line, characterised by the steps of:-

electrically isolating the sources from the ground line; and
applying electrical stress to the memory cell transistors by applying a programming potential to the bit lines and a ground potential to the word lines.

Embodiments of the present invention enable the stress testing of memory devices such as the EPROM explained above in an efficient manner, even when the EPROM is using redundant bit lines because of bit line failure.

Embodiments of the present invention enable testing to be carried out without the need to individually access each memory cell for testing.

Embodiments of the present invention provide erasable programmable non-volatile semiconductor read only memories having redundant bit lines and word lines, and means and method for performing a stress test on all memory cells simultaneously even when a fault is generated in the cell array and redundant bit lines or word lines are used.

An embodiment of the present invention provides an erasable programmable read only memory having a switch (Qf) inserted in the ground line. The switch Qf is ON in normal operation and OFF during the write stress test. The semiconductor memory has non-volatile memory cells which are located at respective intersecting points of a plurality of bit lines and word lines. Drains of the memory cells are connected to the bit lines, while control gates are connected to word lines. Sources are connected to the common ground line through the switch Qf. Each bit line is connected to a write circuit through a column gate, and some of the bit lines are used as redundant bit lines. A stress resistance test method is used to test the semiconductor memory. The switch Qf is turned OFF during the stress test so that all cells can be tested simultaneously, without problems created by short-circuits.

Reference is made, by way of example, to the accompanying drawings, in which:-

Fig. 1 is a schematic diagram for assistance in explaining the general operation of an EPROM;
Fig. 2 is a diagram for assistance in explaining the general operation of a memory cell in the EPROM of Fig. 1;
Fig. 3 is a schematic diagram for assistance in explaining the effects of a short-circuit in an EPROM resembling that of Fig. 1;
Fig. 4 is a block diagram of an EPROM to which an embodiment of the present invention is applied;
Fig. 5 is a schematic block diagram of a circuit for directing signals to redundant memory cells;
Fig. 6 is a schematic diagram of a circuit of a semiconductor memory device embodying the present invention;
Fig. 7(a) and Fig. 7(b) are block diagrams of test control circuits according to embodiments of the present invention;
Fig. 8(a) and Fig. 8(b) are detailed circuit diagrams relating to Fig. 7(a);
Fig. 9 is a detailed circuit diagram relating to Fig. 7 (b); and
Fig. 10 is an operation timing diagram relating to the circuit shown in Fig. 9.

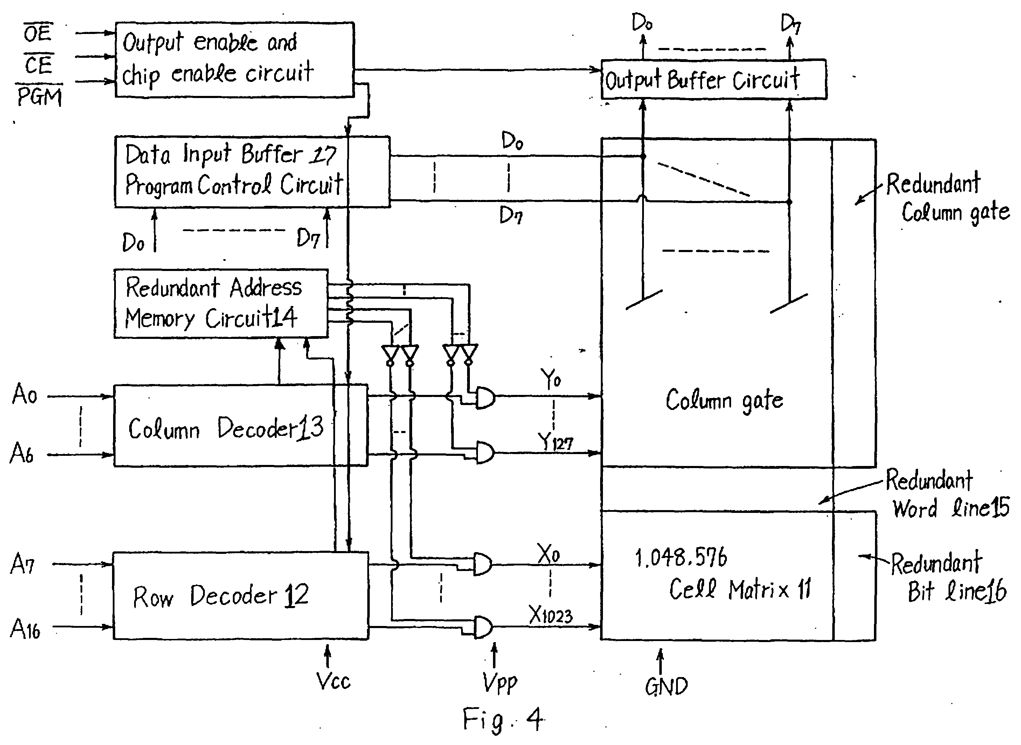

The EPROM of Fig. 4 has redundant cell arrays. In Fig. 4, a cell matrix 11 has 1,048,576 capacitor cells formed by memory elements arranged at the intersecting points of word lines and bit lines. The matrix 11 has a row decoder 12 and column decoder 13, which receive signals supplied to address signal lines A0 - A16 to select cells. Here, in order to replace defective bit lines and word lines, the circuit is provided with a redundant address memory circuit 14 for storing addresses corresponding to the defective bit (word) lines. When a stored address of redundant address memory circuit 14 matches with information output from the row decoder 12 and column decoder 13, access is not carried out to the cell matrix 11 from the row decoder 12 and column decoder 13, and access to the (normal) cell matrix 11 is replaced with access to a redundant word line 15 or a redundant bit line 16. A data input buffer 17 is provided which includes a program control circuit. The program control circuit is used to write information to the device.

As a testing method for the circuit of Fig. 4, when the number of memory cells in the circuit is not so high, it may be possible to test only the operable bit lines and the bit lines corresponding to the redundant addresses to perform the test and thereby give stress to many cells simultaneously by utilising the characteristic of redundancy. Therefore, a circuit for such function conversion will be explained.

Usually, with a redundant cell array device, the function of replacing a defective cell array with a redundant cell array is performed by assigning the address of the defective cell array to the so-called redundant cell array. This assignment function or procedure may be followed by a testing function or procedure in which a voltage is applied simultaneously to all cells by (1) suppressing the output of the decoder corresponding to the address of the defective cell array, and (2) turning ON all other decoder outputs. Such conditions may be explained in detail.

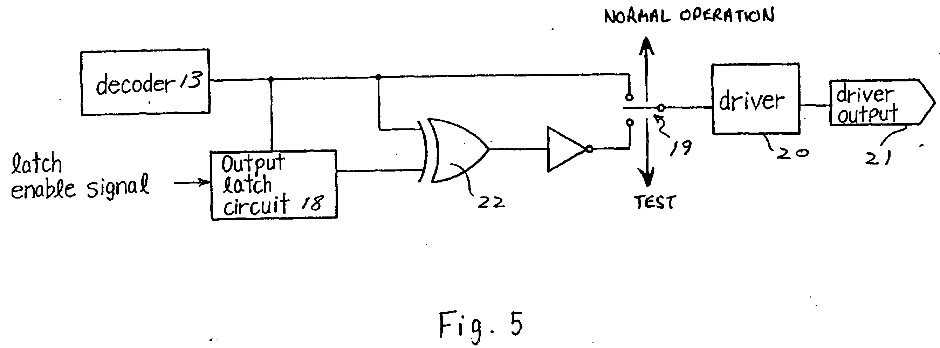

Fig. 5 is a diagram illustrating a circuit which could be used for such address conversion. In Fig. 4 and Fig. 5, the operation sequence is as follows:-

1. An address is read from the redundant address memory circuit 14 and then it is input to a data input buffer 17.

2. With an input to the buffer 17, the decoder 13 latches a decoder output in a latch circuit 18.

3. During normal operation, a switch 19 is in the "up" position in Fig. 5, and the output of the decoder 13 is routed to the appropriate column through a driver 20, which produces driver output 21.

4. The test function is operated by placing the switch 19 "down" in Fig. 5, setting all outputs of the decoder 13 to "L", enabling the latch circuit 18 through a program control circuit in the buffer 17, and inputting the logical value of the inverted signal of an exclusive OR (EXOR) gate 22 to the driver 20.

Although the circuit of Fig. 5 could be employed, it would require substantial redesign of the column decoder 13 in Fig. 4, to include the circuit of Fig. 5.

The inventors propose embodiments of the present invention which do not require changes in the structure of the column decoder 13 in Fig. 4. With such embodiments, applied to the circuit of Fig. 4, stress can be applied simultaneously to all cells with a simplified circuit structure.

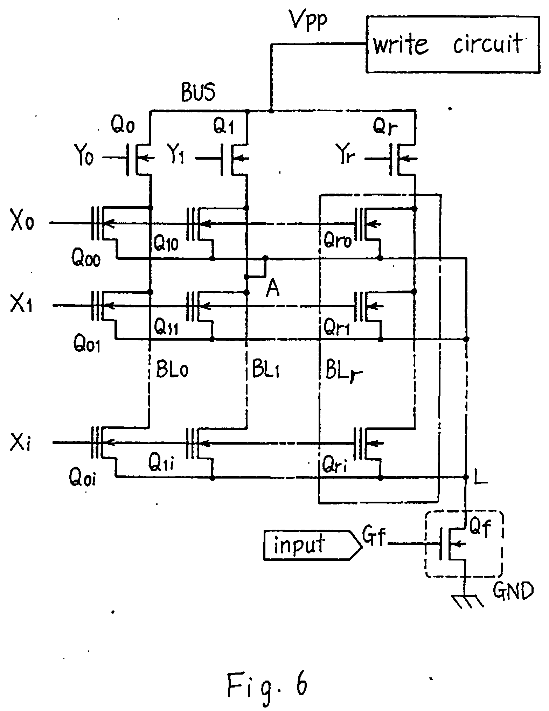

Fig. 6 is a diagram for explaining the circuit of an EPROM in accordance with an embodiment of the present invention. As shown in Fig. 6, in the embodiment of the present invention, a switch Qf is inserted in common ground line L of the memory cells Q00, Q10, ... formed by N-channel MOSFETs. The switch Qf is turned ON/OFF by a signal Gf. The switch Qf is formed by an N-channel FET in this case. When the signal Gf is ON, the switch Qf turns OFF. During the write stress test, the signal Gf is L and the switch Qf is OFF.

Thereby, even when a short-circuit is generated from a bit line to the ground line and a redundant bit line is used in place of the defective bit line, the write stress test can be executed. Namely, when all bit lines are selected and a high voltage Vpp is applied during the write stress test, a heavy current does not flow to ground because the transistor switch Qf is turned OFF. For example, if the short-circuit is generated at the point A, a current does not flow through the path VPP - Q1 - BL1 - A - L - GND. Gates X0, X1, ..., Xi are set to a low level, so a high voltage is applied across the drain and gate of the memory cells. Thus, even if the gate insulation film of a memory cell is defective, the write stress test can still be conducted.

Thus, the circuit of Fig. 6 is similar to the circuit of Fig. 3, but differs in that a switch (N-channel FET) Qf is provided on the common GND line. This switch can be turned OFF by applying the signal Gf to the gate only during the stress test. In other respects, the EPROM of Fig. 6 operates like the device shown in Fig. 4.

In Fig. 6, write operation can be carried out in respect of all cells during the write stress test when Y0, Y1, ..., Yr are set to H to turn ON Q0, Q1, Qr, and all bit lines BL0, BL1, ..., BLr are set to a high voltage. X0, X1, ..., Xi are set to L, Gf is also set to L and Qf is turned OFF. Accordingly, the common ground line L is floated. If a short-circuit occurs at the point A between the bit line BL1 and common ground line L, current does not flow to the ground GND. Thereby, a high voltage can be applied to all bit lines, and therefore to the drain regions of all memory cells.

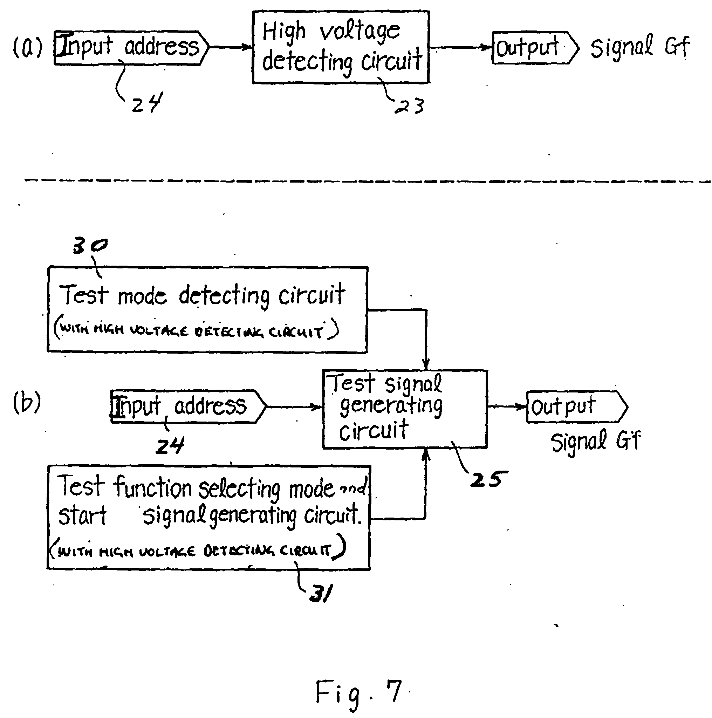

The control signal Gf may be generated in response to a high voltage input to a test control circuit as shown in Figs. 7(a) or 7(b).

In the circuit shown in Fig. 7(a), the signal Gf is fixed at "H" level when the voltage of an address input is within the normal range, for example, a voltage range between 0 volt and 5 volt. On the other hand, when the input voltage at the terminal 24 is out of the normal range, it is detected by the high voltage detection circuit 23. The signal Gf becomes "L" in response to the detection of the high voltage, for example, 9 volt. Thereby, the mode is changed from the normal mode to the test mode. If the high voltage is not continuously applied to the input terminal 24, the test mode is not activated. Since one of the address input terminals is used in the embodiment of Fig. 7(a) for the high voltage input, not all addresses can be scanned during the test mode.

In the case of the test control circuit shown in Fig. 7 (b), since the input signal at the input terminal 24 is latched by the test control circuit, even if the high voltage is released, all address terminals are available for the test operation after the mode is changed to the test mode. Therefore, with the circuit of Fig. 7(b), it is possible to scan all addresses while the test function is operated.

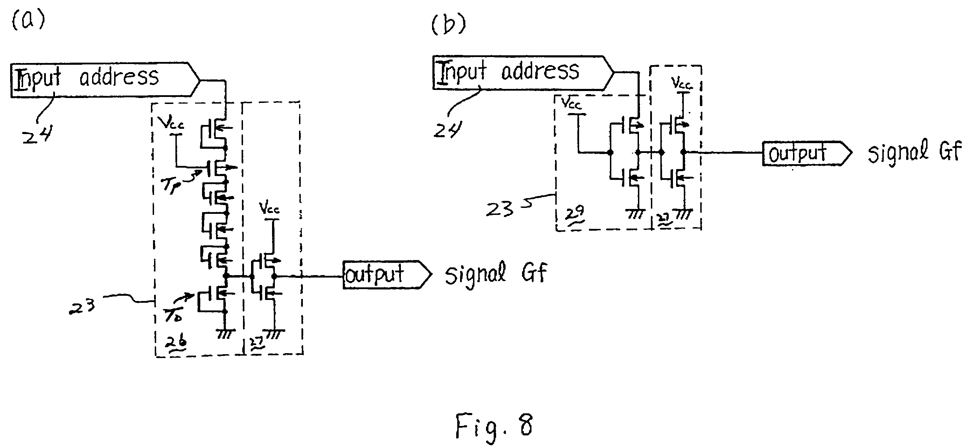

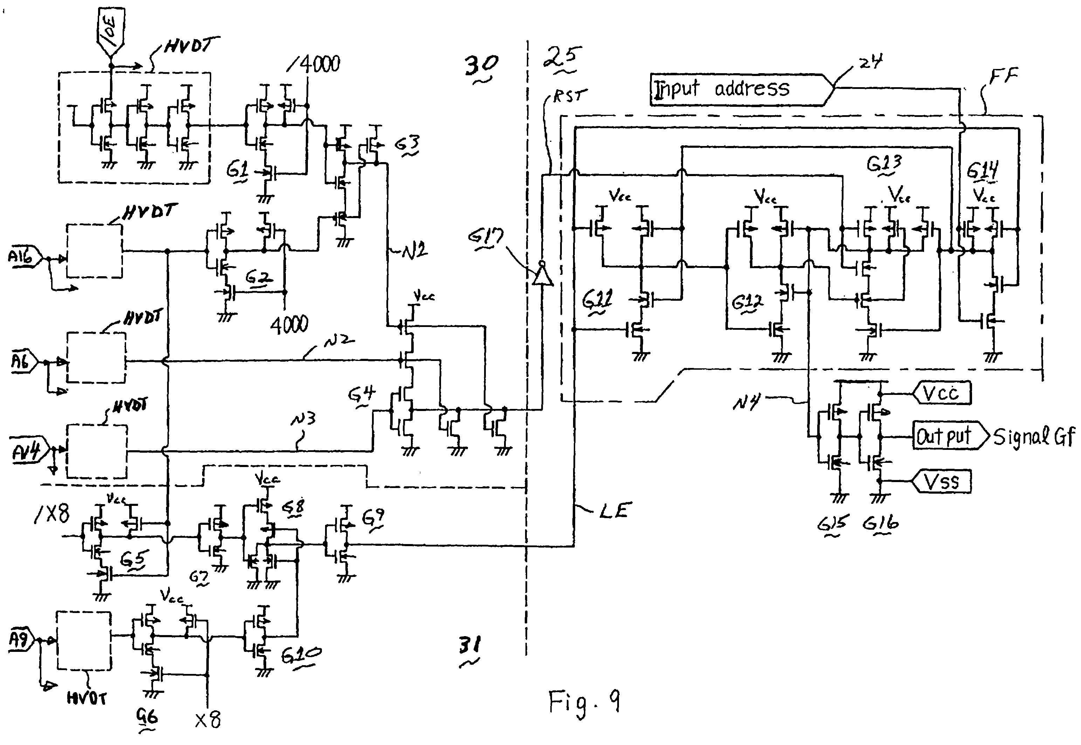

Further detailed circuity arrangements are shown in Figs. 8(a) and 8(b) and Fig. 9. Figs. 8 correspond to the circuit (a) of Fig. 7, while Fig. 9 corresponds to the circuit (b).

In Fig. 8(a), when the voltage at the terminal 24 is between 0 volt and 5 volt, the signal Gf is fixed at "H" regardless of the logic level of the input address since TD (an N-channel depletion MOS transistor) is ON and TP (a P-channel enhancement MOS transistor) is OFF. When the voltage at the input terminal 24 is higher than 5 volt, which is out of normal input range, TP is turned on. Thereby, the signal Gf becomes "L".

In Fig. 8(b), when the voltage at the terminal 24 is between 0 volt and 5 volt, the signal Gf is fixed at "H" regardless of the logic level of the input address since the P-channel transistor is off and the N-channel transistor is on in the CMOS inverter 29. When the voltage at the input terminal is higher than 5 volt, the signal Gf becomes "L" since the P-channel transistor is turned on and N-channel transistor is turned off in the CMOS inverter 29.

In Fig. 9, input address signals A6, A9, A14, A16 and output enable signal /OE are applied to high voltage detection circuits HVDT. These signals are also supplied to input buffer circuits of the memory circuit which are not shown in Fig. 9.

An output signal of a high voltage detection circuit HVDT is "L" (logical L level) when the input signal is within a normal input voltage range, 0 volt to 5 volt. When a high voltage, higher than 5 volt, is applied to change the mode of the device from the normal mode to the test mode, the output signal of the HVDT becomes "H".

In the normal mode, NAND gates G6 and 68 output "H". A latch enable signal LE is "L", namely inactive. NOR gate G4 outputs "H" since nodes N1 to N3 are at "L" level. Reset signal RST is "L", namely inactive. NAND gate G13 outputs "H" to node N4 regardless of the level of the input address (24) applied to flip-flop circuit FF. Therefore, signal Gf is fixed at "H" level during the normal mode.

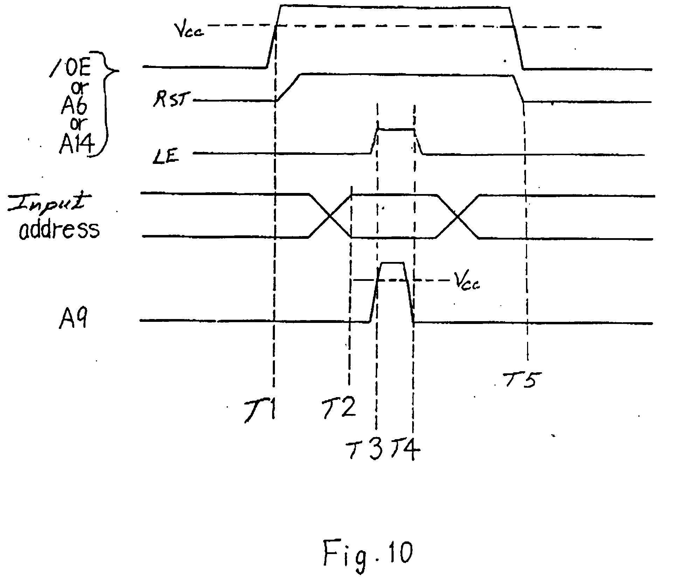

In the test mode, assuming that a signal 4000 is "L" and a signal /4000 is "H", an input terminal /OE is used to receive the high voltage rather than A16. To make the reset signal RST active "H", high voltage, which is higher than maximum normal input voltage 5 volt, is applied to one of the input terminals /OE, A6 or A14. To make the latch enable signal LE active "H", high voltage, which is higher than maximum normal input voltage 5 volt, is applied to the input terminal A9. The mode is changed from the normal mode to the test mode as follows. At time T1 shown in Fig. 10, the reset signal RST becomes "H" in response to the high voltage applied to one of input terminals /OE, A6 and A14. At this time, N4 still remains at "H", but the state of the flip-flop circuit FF is changeable in response to LE and the input address. At time T2 shown in Fig. 10, the input address applied to the FF becomes valid. At time T3, the latch enable signal LE becomes active "H" in response to the high voltage applied to the input terminal A9. When LE changes from "L" to "H", the logic level of the input address is latched by the flip-flop FF. If the input address is "L" when LE rises, the signal Gf becomes "L". If the input address is "H" when LE rises, the signal Gf remains "H". At time T4, the latch enable signal LE becomes "L" in response to release of the high voltage at the input terminal A9. At the time T5, the high voltage at one of /DE, A6, and A14 is released. However, the logic level of the input address latched at time T3 is kept in the flip-flop circuit until the RST and LE become active again. Thus, it is not necessary to apply the high voltage continuously during the test mode according to the embodiment of Fig. 9. Therefore, after the mode is changed to the test mode, the input terminals can be used for inputting addresses or other input signals during the test mode. It is not necessary to provide a special test control terminal according to the embodiment of Fig. 9.

It might also be considered that when bit line redundancy is used, circuitry could be designed so that the defective bit lines are no longer selected, even in the write stress test (Y1 is not set to H in the example shown in Fig. 6). However, in such a case, the structure of the column gate selection circuit is complicated. The method of inserting the switch Qf to the common ground line is simple in structure and only requires that the signal Gf is set to L during the write stress test.

As explained above, an embodiment of the present invention can provide for performance of the write stress test even for an EPROM which uses bit line redundancy, and can avoid test failure due to problems with gate oxide film. Thereby, the present invention can provide for remarkable improvements in device reliability.

In the above-described embodiments, only one switch Qf is provided, on the common GND line, but it is also possible to provide an individual switch Qf for each bit line, word line, or other part of the memory cells.

An EPROM fails if memory cells mistakenly release accumulated charges. This can happen if the stored information in a cell is lost due to electrical stress suffered when information is written into adjacent cells. In order to solve this problem, a so-called stress test is conducted to selectively isolate the cells which cannot withstand such stress. Since the write or read operation in an EPROM is sequentially conducted for individual cells, a longer time is taken for write or read operations but, such operations may be continued by replacing the defective cells with redundant cells. However, the stress test is preferably conducted by stressing all cells simultaneously, in order to improve efficiency. The present invention provides a capability for applying specified stress to all cells simultaneously, even if the power supply line is short-circuited to ground due to failure in one or more memory cells in the cell array. As a means for attaining this purpose, the common GND line and the short-circuit point are separated when a stress test voltage is applied.

**Claims**

1.  A semiconductor non-volatile memory device, having a normal operating mode and a test mode, comprising:-

    a plurality of bit lines (BL0, BL1, BLr);
    a plurality of word lines (X0, X1, Xi) which intersect said bit lines;
    a plurality of non-volatile memory cells (Q00, Q10, to Q1i), each having a drain, a control gate and a source, the cells being connected to said bit lines and said word lines where said bit lines and said word lines intersect, with the drains connected to said bit lines and the control gates connected to said word lines; and
    a supply line (GND) for supplying at least one predetermined potential to the sources of all of said memory cells;
    characterised by
    means (Qf) for electrically isolating the sources of said memory cells from said supply line responsive to a control signal (Gf), said isolating means including a switch circuit (Qf) which is turned on to supply said predetermined potential to the sources of said memory cells commonly during the normal operating mode, said switch circuit being turned off during the test mode to isolate said supply line from the sources of said memory cells.

2. A semiconductor non-volatile memory device according to claim 1, wherein said memory cells are normally operated within a normal voltage range, said device further comprising:-

a plurality of input terminals (24; A1 to A16, /0E, $\overline{OE}$ ) for receiving external signals; and a test mode control circuit, connected to such an input terminal and to said switch circuit (Qf), for generating said control signal (Gf), said test mode control circuit turning said switch circuit (Qf) off in response to a high voltage which exceeds the normal voltage range, said high voltage being applied to the said input terminal.

3. A semiconductor non-volatile memory device according to claim 1, wherein said memory cells are normally operated within a normal voltage range, said device further comprising:-

first (A16, A6, A14, /0E), second (A9) and third (24) input terminals for receiving external signals; and a test mode control circuit, connected to said first, second and third input terminals and to the switch circuit (Qf), for generating said control signal, said test mode control circuit including:-

a flip-flop (FF) circuit having a reset (RST) terminal, a latch enable (LE) terminal, an input terminal and an output terminal, a first high voltage detection circuit (30) for supplying a reset signal (RST) to said reset terminal when a high voltage outside the normal operating range is applied to said first terminal (A16, A6, A14, /OE), and a second high voltage detection circuit (31) for supplying a latch enable signal (LE) to said latch enable terminal when said high voltage is applied to said second terminal (A9),

wherein an input signal applied to said third terminal (24) is latched in said flip-flop circuit (FF) in response to said latch enable signal (LE).

4. A semiconductor non-volatile memory device according to claim 3, wherein said first, second and third input terminals are address input terminals.

5. A semiconductor non-volatile memory device according to any preceding claim, wherein said predetermined potential is a ground potential (GND).

6. A semiconductor non-volatile memory device according to any preceding claim, wherein said non-volatile memory cells (Q00, Q10, to Q1i) comprise FAMOS transistors.

7. A semiconductor non-volatile memory device according to any preceding claim, said device further comprising a redundant memory cell array having a redundant bit line (BLr) connected to said switch circuit (Qf), said redundant bit line being isolated from said supply line (GND) by said switch circuit during the test mode.

8. A semiconductor non-volatile memory device according to any preceding claim, said device further comprising means for supplying a programming voltage to said bit lines (BL0, BL1, BLr) during the test mode and supplying a ground potential to said word lines.

9. A semiconductor non-volatile memory device according to any preceding claim, being an erasable programmable memory, wherein

some of said bit lines (BLr) are used as redundant bit lines, the device further comprises a write circuit for permanently storing information in selected said memory cells, said bit lines also being connected to said write circuit, and the said means (Qf) for electrically isolating said sources from said supply line (GND) are employed for the purpose of conducting a stress test on all of said memory cells simultaneously.

10. A memory according to claim 9, wherein all of said sources are connected to a ground connection through a single, common ground line, said isolating means comprising a single switch (Qf) disposed between said ground connection and said ground line, said switch being ON during normal operation, and OFF during said stress test.

11. A memory according to claim 10, wherein said isolating means further comprises means for generating a control signal for said switch in response to a selected input address signal.

12. A memory according to claim 11, wherein said control signal is only generated when said address signal is present.

13. A memory according to claim 11, wherein said control signal is latched on in response to said address signal, and remains on until said control signal is reset, irrespective of whether said address signal is continuously present.

14. A method for testing a semiconductor non-volatile memory device having a plurality of bit lines (BL0, BL1, BLr), a plurality of word lines (X0, X1, Xi) which intersect the bit lines, and a plurality of non-volatile memory cell transistors (Q00, Q10 to Q1i), each having a drain, a control gate and a source, connected to the bit lines and the word lines where the bit lines and the word lines intersect, with the drains connected to said bit lines and the control gates connected to said word lines, the sources having a connection to a ground line (GND), characterised by the steps of:-

electrically isolating the sources from the ground line (GND); and
applying electrical stress to the memory cell transistors by applying a programming potential to the bit lines and a ground potential to the word lines.

**Patentansprüche**

1. Eine nichtflüchtige Halbleiterspeichervorrichtung, die einen normalen Betriebsmodus und einen Testmodus hat, mit:-

einer Vielzahl von Bitleitungen (BL0, BL1, BLr);
einer Vielzahl von Wortleitungen (X0, X1, Xi), die die genannten Bitleitungen kreuzen;
einer Vielzahl von nichtflüchtigen Speicherzellen (Q00, Q10, bis Q1i), die jeweils ein Drain, ein Steuergate und eine Source haben, welche Zellen mit den genannten Bitleitungen und den genannten Wortleitungen verbunden sind, wo sich die genannten Bitleitungen und die genannten Wortleitungen kreuzen, wobei die Drains mit den genannten Bitleitungen verbunden sind und die Steuergates mit den genannten Wortleitungen verbunden sind; und
einer Zuführleitung (GND) zum Zuführen von wenigstens einem vorbestimmten Potential zu den Sources aller der genannten Speicherzellen;
gekennzeichnet durch
ein Mittel (Qf) zum elektrischen Isolieren der Sources der genannten Speicherzellen von der genannten Zuführleitung als Reaktion auf ein Steuersignal (Gf), welches Isoliermittel einen Schalterstromkreis (Qf) umfaßt, der eingeschaltet wird, um das genannte vorbestimmte Potential den Sources der genannten Speicherzellen während des normalen Betriebsmodus gemeinsam zuzuführen, welcher Schalterstromkreis während des Testmodus ausgeschaltet wird, um die genannte Zuführleitung von den Sources der genannten Speicherzellen zu isolieren.

2. Eine nichtflüchtige Halbleiterspeichervorrichtung nach Anspruch 1, bei der die genannten Speicherzellen innerhalb eines normalen Spannungsbereiches normal betrieben werden, welche Vorrichtung ferner umfaßt:-

eine Vielzahl von Eingangsanschlüssen (24; A1 bis A16, /OE, $\overline{OE}$) zum Empfangen von externen Signalen; und
eine Testmodussteuerschaltung, die mit solch einem Eingangsanschluß und mit dem genannten Schalterstromkreis (Qf) verbunden ist, zum Erzeugen des genannten Steuersignals (Gf), welche Testmodussteuerschaltung den genannten Schalterstromkreis (Qf) als Reaktion auf eine hohe Spannung, die den normalen Spannungsbereich überschreitet, ausschaltet, welche hohe Spannung auf den genannten Eingangsanschluß angewendet wird.

3. Eine nichtflüchtige Halbleiterspeichervorrichtung nach Anspruch 1, bei der die genannten Speicherzellen innerhalb eines normalen Spannungsbereiches normal betrieben werden, welche Vorrichtung ferner umfaßt:-

erste (A16, A6, A14, /OE), zweite (A9) und dritte (24) Eingangsanschlüsse zum Empfangen von externen Signalen; und
eine Testmodussteuerschaltung, die mit den genannten ersten, zweiten und dritten Eingangsanschlüssen und mit dem Schalterstromkreis (Qf) verbunden ist, zum Erzeugen des genannten Steuersignals, welche Testmodussteuerschaltung enthält:-

eine Flipflop-(FF)-Schaltung mit einem Rücksetz-(RST)-Anschluß, einem Verriegelungsfreigabe-(LE)-Anschluß, einem Eingangsanschluß und einem Ausgangsanschluß,
eine erste Hochspannungs-Detektionsschaltung (30) zum Zuführen eines Rücksetzsignals (RST) zu dem genannten Rücksetzanschluß, wenn eine hohe Spannung außerhalb des normalen Betriebsbereiches auf den genannten ersten Anschluß (A16, A6, A14, /OE) angewendet wird, und
eine zweite Hochspannungs-Detektionsschaltung (31) zum Zuführen eines Verriegelungsfreigabesignals (LE) zu dem genannten Verriegelungsfreigabeanschluß, wenn die genannte hohe Spannung auf den genannten zweiten Anschluß (A9) angewendet wird,

bei der ein Eingangssignal, das auf den genannten dritten Anschluß (24) angewendet wird, in der genannten Flipflopschaltung (FF) als Reaktion auf das genannte Verriegelungsfreigabesignal (LE) verriegelt wird.

4. Eine nichtflüchtige Halbleiterspeichervorrichtung nach Anspruch 3, bei der die genannten ersten, zweiten und dritten Eingangsanschlüsse Adresseneingangsanschlüsse sind.

5. Eine nichtflüchtige Halbleiterspeichervorrichtung nach irgendeinem vorhergehenden Anspruch, bei der das genannte vorbestimmte Potential ein Erdpotential (GND) ist.

6. Eine nichtflüchtige Halbleiterspeichervorrichtung nach irgendeinem vorhergehenden Anspruch, bei der die genannten nichtflüchtigen Speicherzellen (Q00, Q10, bis Q1i) FAMOS-Transistoren umfassen.

7. Eine nichtflüchtige Halbleiterspeichervorrichtung nach irgendeinem vorhergehenden Anspruch, welche Vorrichtung ferner ein redundantes Speicherzellenarray umfaßt, das eine redundante Bitleitung (BLr) hat, die mit dem genannten Schalterstromkreis (Qf) verbunden ist, welche redundante Bitleitung während des Testmodus durch den genannten Schalterstromkreis von der genannten Zuführleitung (GND) isoliert ist.

8. Eine nichtflüchtige Halbleiterspeichervorrichtung nach irgendeinem vorhergehenden Anspruch, welche Vorrichtung ferner ein Mittel umfaßt zum Zuführen einer Programmierspannung zu den genannten Bitleitungen (BL0, BL1, BLr) während des Testmodus und zum Zuführen eines Erdpotentials zu den genannten Wortleitungen.

9. Eine nichtflüchtige Halbleiterspeichervorrichtung nach irgendeinem vorhergehenden Anspruch, die ein löschbarer, programmierbarer Speicher ist, bei der

einige der genannten Bitleitungen (BLr) als redundante Bitleitungen verwendet werden,
die Vorrichtung ferner eine Schreibschaltung umfaßt, zum permanenten Speichern von Informationen in selektierten der genannten Speicherzellen, welche Bitleitungen auch mit der genannten Schreibschaltung verbunden sind, und
das genannte Mittel (Qf) zum elektrischen Isolieren der genannten Sources von der genannten Zuführleitung (GND) zum Zweck des Durchführens eines Belastungstests bei allen der genannten Speicherzellen gleichzeitig verwendet wird.

10. Ein Speicher nach Anspruch 9, bei dem alle der genannten Sources durch eine einzelne, gemeinsame Erdleitung mit einer Erdverbindung verbunden sind, welches Isoliermittel einen einzelnen Schalter (Qf) umfaßt, der zwischen der genannten Erdverbindung und der genannten Erdleitung angeordnet ist, welcher Schalter während normalen Betriebes EIN ist und während des genannten Belastungstests AUS ist.

11. Ein Speicher nach Anspruch 10, bei dem das genannte Isoliermittel ferner ein Mittel zum Erzeugen eines Steuersignals für den genannten Schalter als Reaktion auf ein selektiertes Eingangsadressensignal umfaßt.

12. Ein Speicher nach Anspruch 11, bei dem das genannte Steuersignal nur erzeugt wird, wenn das genannte Adressensignal vorhanden ist.

13. Ein Speicher nach Anspruch 11, bei dem das genannte Steuersignal als Reaktion auf das genannte Adressensignal ein verriegelt wird und ein bleibt, bis das genannte Steuersignal zurückgesetzt wird, ungeachtet dessen, ob das genannte Adressensignal kontinuierlich vorhanden ist.

14. Ein Verfahren zum Testen einer nichtflüchtigen Halbleiterspeichervorrichtung mit einer Vielzahl von Bitleitungen (BL0, BL1, BLr), einer Vielzahl von Wortleitungen (X0, X1, Xi), die die Bitleitungen kreuzen, und einer Vielzahl von nichtflüchtigen Speicherzellentransistoren (Q00, Q10 bis Q1i), die jeweils ein Drain, ein Steuergate und eine Source haben und mit den Bitleitungen und den Wortleitungen verbunden sind, wo sich die Bitleitungen und Wortleitungen kreuzen, wobei die Drains mit den genannten Bitleitungen verbunden sind und die Steuergates mit den genannten Wortleitungen verbunden sind, die Sources eine Verbindung zu einer Erdleitung (GND) haben, gekennzeichnet durch die Schritte:-

elektrisches Isolieren der Sources von der Erdleitung (GND); und
Anwenden von elektrischer Belastung auf die Speicherzellentransistoren durch Anwenden eines Programmierpotentials auf die Bitleitungen und eines Erdpotentials auf die Wortleitungen.

**Revendications**

1. Dispositif de mémoires non-volatiles à semi-conducteur, ayant un mode de fonctionnement normal et un mode de test, comprenant :

une pluralité de lignes binaires (BLO, BL1, BLr) ;

une pluralité de lignes de mots (X0, X1, Xi) qui coupent lesdites lignes binaires ;

une pluralité de cellules de mémoires non-volatiles (Q00, Q10 à Q1i), ayant chacune un drain, une grille de commande et une source, les cellules étant reliées auxdites lignes binaires et auxdites lignes de mots où lesdites lignes binaires et lesdites lignes de mots se coupent, avec les drains reliés auxdites lignes binaires et les grilles de commande reliées auxdites lignes de mots ; et

une ligne d'alimentation (GND) pour fournir au moins un potentiel prédéterminé aux sources de toutes lesdites cellules de mémoire ; caractérisé par

un dispositif (Qf) pour isoler électriquement les sources desdites cellules de mémoire de ladite ligne d'alimentation en réponse à un signal de commande (Gf), ledit dispositif d'isolation comprenant un circuit de commutation (Qf) qui est conducteur pour fournir ledit potentiel prédéterminé aux sources desdites cellules de mémoire généralement pendant le mode de fonctionnement normal, ledit circuit de commutation étant bloqué pendant le mode de test pour isoler ladite ligne d'alimentation des sources desdites cellules de mémoire.

2. Dispositif de mémoires non-volatiles à semi-conducteur selon la revendication 1, dans lequel lesdites cellules de mémoire sont normalement utilisées dans un intervalle de tension normale, ledit dispositif comprenant en outre :

une pluralité de bornes d'entrée (24 ; A1 à A16 /OE, $\overline{OE}$ ) pour recevoir des signaux externes ; et

un circuit de commande de mode de test, relié à une telle borne d'entrée et audit circuit de commutation (Qf), pour générer ledit signal de commande (Gf), ledit circuit de commande de mode de test bloquant ledit circuit de commutation (Qf) en réponse à une tension de niveau haut qui dépasse l'intervalle de tension normal, ladite tension de niveau haut étant appliquée à ladite borne d'entrée.

3. Dispositif de mémoires non-volatiles à semi-conducteur selon la revendication 1, dans lequel lesdits cellules de mémoire sont normalement actionnées dans un intervalle de tension normal, ledit dispositif comprenant en outre :

des première (A16, A6, A14, /OE), seconde (A9) et troisième (24) bornes d'entrée pour recevoir des signaux externes ; et

un circuit de commande de mode de test, relié auxdites première, seconde et troisième bornes d'entrée et au circuit de commutation (Qf), pour générer ledit signal de commande, ledit circuit de commande de test comprenant :

un circuit de bascule (FF) ayant une borne de réinitialisation (RST), une borne de validation de verrouillage (LE), une borne d'entrée et une borne de sortie,

un premier circuit de détection de tension de niveau haut (30) pour fournir un signal de réinitialisation (RST) à ladite borne de réinitialisation lorsqu'une tension de niveau haut en dehors de l'intervalle de fonctionnement normal est appliquée à ladite première borne (A16, A6, A14 / OE), et

un second circuit de détection de tension de niveau haut (31) pour fournir un signal de validation de verrouillage (LE) à ladite borne de validation de verrouillage lorsque ladite tension de niveau haut est appliquée à ladite seconde borne (A9),

dans lequel un signal d'entrée appliqué à ladite troisième borne (24) est verrouillé dans ledit circuit de bascule (FF) en réponse audit signal de validation de verrouillage (LE).

4. Dispositif de mémoires non-volatiles à semi-conducteur selon la revendication 3, dans lequel lesdites première, seconde et troisième bornes d'entrée sont des bornes d'entrée d'adresse.

5. Dispositif de mémoires non-volatiles à semi-conducteur selon l'une quelconque des revendications précédentes, dans lequel ledit potentiel prédéterminé est un potentiel de masse (GND).

6. Dispositif de mémoires non-volatiles à semi-conducteur selon l'une quelconque des revendications précédentes, dans lequel lesdites cellules de mémoire non-volatiles (Q00, Q10 à Q1i) comprennent des transistors FAMOS.

7. Dispositif de mémoires non-volatiles à semi-conducteur selon l'une quelconque des revendications précédentes, ledit dispositif comprenant en outre un réseau de cellules de mémoire redondantes ayant une ligne binaire redondante (BLr) reliée audit circuit de commutation (Qf), ladite ligne binaire redondante étant isolée de ladite ligne d'alimentation (GND) par ledit circuit de commutation pendant le mode de test.

8. Dispositif de mémoires non-volatiles à semi-conducteur selon l'une quelconque des revendications précédentes, ledit dispositif comprenant en outre un dispositif pour fournir une tension de programmation auxdites lignes binaires (BL0, BL1, BLr) pendant le mode de test et pour fournir un potentiel de masse auxdites lignes de mots.

9. Dispositif de mémoires non-volatiles à semi-conducteur selon l'une quelconque des revendications précédentes, étant une mémoire programmable effaçable, dans lequel

certaines desdites lignes binaires (BLr) sont utilisées comme des lignes binaires redondantes, le dispositif comprend en outre un circuit d'écriture pour stocker de façon permanente des informations dans lesdites cellules de mémoire sélectionnées, lesdites lignes binaires étant aussi reliées audit circuit d'écriture, et
ledit dispositif (Qf) pour isoler électriquement lesdites sources desdites lignes d'alimentation (GND) sont utilisées dans le but de conduire un test de contrainte de façon simultanée sur toutes lesdites cellules de mémoire.

10. Mémoire selon la revendication 9, dans laquelle toutes lesdites sources sont reliées à une liaison de masse à travers une ligne de masse commune unique, ledit dispositif d'isolation comprenant un commutateur unique (Qf) disposé entre ladite connexion de masse et ladite ligne de masse, ledit commutateur étant conducteur pendant un fonctionnement normal, et bloqué pendant ledit test de contrainte.

11. Mémoire selon la revendication 10, dans laquelle ledit dispositif d'isolation comprend en outre un dispositif pour générer un signal de commande pendant ladite commutation en réponse à un signal d'adresse d'entrée sélectionné.

12. Mémoire selon la revendication 11, dans laquelle ledit signal de commande est généré seulement lorsque ledit signal d'adresse est présent.

13. Mémoire selon la revendication 11, dans laquelle ledit signal de commande est verrouillé de façon conducteur en réponse audit signal d'adresse, et reste jusqu'à ce que ledit signal de commande soit réinitialisé, indépendamment de si ledit signal d'adresse est présent de façon continue.

14. Procédé pour tester un dispositif de mémoires non-volatiles à semi-conducteur ayant une pluralité de lignes binaires (BL0, BL1, BLr), une pluralité de lignes de mots (X0, X1, Xi) qui coupent les lignes binaires, et une pluralité de transistors de cellules de mémoire non-volatiles (Q00, Q10 à Q1i), ayant chacune un drain, une grille de commande et une source, reliés aux lignes binaires et aux lignes de mots où les lignes binaires et les lignes de mots se coupent, avec les drains reliés auxdites lignes binaires et les grilles de commande reliées auxdites lignes de mots, les sources ayant une liaison à une ligne de masse (GND) caractérisé par les étapes de :

isolation électriquement des sources de la ligne de masse (GND) ; et
application d'une contrainte électrique au transistor de cellules de mémoire en appliquant un potentiel de programmation aux lignes binaires et un potentiel de masse aux lignes de mots.

Fig.1

Fig.2

Fig. 3

Fig. 4

OE

CE

PGM

Output enable and chip enable circuit

Data Input Buffer 17
Program Control Circuit

$D_0$

$D_7$

Redundant Address Memory Circuit 14

$A_0$

$A_6$

Column Decoder 13

$A_7$

$A_{16}$

Row Decoder 12

$Y_0$

$Y_{127}$

$X_0$

$X_{1023}$

$D_0$

$D_7$

Output Buffer Circuit

Column gate

Redundant Column gate

1.048.576
Cell Matrix 11

Redundant Word line 15

Redundant Bit line 16

Vcc

Vpp

GND

EP 0 427 260 B1

Fig. 5

Fig. 6

(a) Input address ⟩ → High voltage detecting circuit → Output ⟩ Signal Gf

24    23

- - - - - - - - - - - - - - - - - - - - - - - - - - - - - - - - - - - - -

30

Test mode detecting circuit
(WITH HIGH VOLTAGE DETECTING CIRCUIT)

(b)   Input address ⟩ → Test signal generating circuit → Output ⟩

24    Signal Gf

Test function selecting mode and start signal generating circuit.
(WITH HIGH VOLTAGE DETECTING CIRCUIT)

25

31

Fig. 7

(a)

Input address

24

23

26  27

$V_{cc}$

$T_f$

$V_{cc}$

$T_0$

output  signal Gf

(b)

Input address

24

23

29  27

$V_{cc}$  $V_{cc}$

output  signal Gf

Fig. 8

EP 0 427 260 B1

Fig. 9

Fig.10